# EUROPÄISCHE PATENTSCHRIFT

(11) **EP 2 126 974 B1**
(45) Veröffentlichungstag und Bekanntmachung des Hinweises auf die Patenterteilung: **15.10.2014**
(21) Anmeldenummer: 08715899.4
(22) Anmeldetag: 20.02.2008
(51) Int. Cl.: H01L 27/16, H01L 35/32, H01L 35/34, B65H 55/04, B21F 9/00, H01F 41/06

(54) **THERMOSÄULENSTRANG**
THERMOPILE WIRE
FAISCEAU DE THERMOPILE

(30) Priorität: 26.02.2007 DE 102007009221
(43) Veröffentlichungstag der Anmeldung: 02.12.2009
(73) Patentinhaber: Isabellenhütte Heusler GmbH & Co.KG, 35683 Dillenburg (DE)
(72) Erfinder: HETZLER, Ullrich, 35688 Dillenburg-Oberscheld (DE)
(74) Vertreter: Beier, Ralph
(86) Internationale Anmeldenummer: PCT/EP2008/001329
(87) Internationale Veröffentlichungsnummer: WO 2008/104312

(56) Entgegenhaltungen:
- WO-A-01/29907
- DD-A1- 103 763
- DE-A1- 2 027 240
- DE-A1- 3 420 294
- DE-A1-102007 009 221
- DE-U1-202006 003 595
- JP-A- 61 097 908
- JP-A- 2004 241 657
- US-A- 1 923 898
- US-A- 2 674 641
- US-A- 2 768 424
- US-A- 3 305 393
- US-A- 3 512 248
- US-A- 3 690 955

## Beschreibung

Die Erfindung betrifft einen Thermosäulenstrang.

Aus der Gebrauchsmusterschrift DE 20 2006 003 595 U1 ist ein Thermosäulenstrang bekannt, der zahlreiche hintereinander angeordnete und elektrisch in Reihe geschaltete Thermoelemente aufweist und zur Herstellung eines thermoelektrischen Generators ("Thermokonverter") verwendet werden kann, indem der Thermosäulenstrang so auf einen Wicklungsträger aufgewickelt wird, dass die heißen Verbindungsstellen einerseits und die kalten Verbindungsstellen andererseits auf gegenüberliegenden Seiten des Wicklungsträgers angeordnet sind. Bei einer Temperaturdifferenz zwischen den gegenüberliegenden Seiten des Wicklungsträgers erzeugt der aufgewickelte Thermosäulenstrang dann eine entsprechende Thermospannung.

Hierbei tritt das Problem auf, dass sich beim Bewickeln des Wicklungsträgers mit mehreren übereinanderliegenden Wicklungslagen des Thermosäulenstrangs der effektive Wicklungsumfang von einer Wicklungslage zur nächsten Wicklungslage ändert. Bei einer einheitlichen Länge der einzelnen Thermoelemente in dem Thermosäulenstrang hat dies wiederum zur Folge, dass die heißen bzw. kalten Verbindungsstellen des Thermosäulenstrangs in den einzelnen Wicklungslagen gegenüber der vorgegebenen Position versetzt sind. Es ist jedoch wünschenswert, dass die heißen Verbindungsstellen einerseits und die kalten Verbindungsstellen andererseits einander exakt und ohne Ausrichtungsfehler gegenüberliegen.

Zum Stand der Technik ist ferner hinzuweisen auf US 3 357 866 A, US 3 700 503 A, DD 103 763 A1, US 3 150 844 A, GB 819 273 A, DE 195 29 725 A1, DE 43 35 089 A1, DE 17 74 229 B2, DE 34 20 294 A1. Diese Entgegenhaltungen betreffen jedoch größtenteils thermoelektrische Generatoren mit einer einlagigen Wicklung des Thermosäulenstrangs, so dass der Wicklungsdurchmesser des Thermosäulenstrangs konstant ist. Eine gezielte Anpassung der Länge der einzelnen Thermoelemente bzw. Thermoelementschenkel ist aus diesen Entgegenhaltungen jedenfalls nicht bekannt.

Der Erfindung liegt also die Aufgabe zugrunde, das Problem der Fehlpositionierung der heißen bzw. kalten Verbindungsstellen des Thermosäulenstrangs in den aufeinanderfolgenden Wicklungslagen zu lösen.

Diese Aufgabe wird durch einen erfindungsgemäßen Thermosäulenstrang gelöst.

Die Erfindung umfasst zunächst einen Thermosäulenstrang, der weitgehend mit einem herkömmlichen Thermosäulenstrang übereinstimmt, wie er beispielsweise in der Gebrauchsmusterschrift DE 20 2006 003 595 U1 beschrieben ist. Zur Vermeidung von Wiederholungen wird deshalb hinsichtlich des konstruktiven Aufbaus und der Herstellung eines erfindungsgemäßen Thermosäulenstrangs auf die vorstehende Gebrauchsmusterschrift verwiesen, deren Inhalt der vorliegenden Anmeldung in vollem Umfang zuzurechnen ist.

Der erfindungsgemäße Thermosäulenstrang zeichnet sich gegenüber dem vorstehend genannten herkömmlichen Thermosäulenstrang dadurch aus, dass die Länge der einzelnen Thermoelemente und/oder die Länge der einzelnen Thermoelementschenkel entlang dem Thermosäulenstrang nicht konstant ist. Vielmehr sieht die Erfindung vor, dass die Länge der einzelnen Thermoelemente und/oder die Länge der einzelnen Thermoelementschenkel entlang den Thermosäulenstrang monoton zunimmt oder monoton abnimmt. Diese Längenänderung der einzelnen Thermoelemente bzw. Thermoelementschenkel ermöglicht es, dass die heißen bzw. kalten Verbindungsstellen im aufgewickelten Zustand trotz der Änderung des effektiven Wicklungsdurchmessers von einer Wicklungslage zur nächsten Wicklungslage exakt an der vorgesehenen Position liegen.

In einer Variante des erfindungsgemäßen Thermosäulenstrangs weisen alle unmittelbar aufeinanderfolgenden Thermoelemente und/oder Thermoelementschenkel jeweils eine vorgegebene Längendifferenz auf. Dies bedeutet, dass jedes Thermoelement bzw. jeder Thermoelementschenkel gegenüber dem unmittelbar vorangehenden Thermoelement bzw. Thermoelementschenkel eine vorgegebene Längendifferenz aufweist. Diese Variante eignet sich insbesondere dann, wenn auf dem Wicklungsträger keine Windungen nebeneinander liegen, so dass jede Windung eine neue Wicklungslage bildet.

In einer andern Variante eines erfindungsgemäßen Thermosäulenstrangs weisen die unmittelbar aufeinanderfolgenden Thermoelemente und/oder Thermoelementschenkel dagegen nur bei jedem n-ten Thermoelement eine vorgegebenen Längendifferenz auf und haben ansonsten die gleiche Länge. Die Thermoelemente sind hierbei also in aufeinanderfolgende Gruppen eingeteilt, wobei die Thermoelemente bzw. Thermoelementschenkel in den einzelnen Gruppen jeweils die gleiche Länge aufweisen, während die Thermoelemente bzw. Thermoelementschenkel in den unmittelbar aufeinanderfolgenden Gruppen eine vorgegebene Längendifferenz aufweisen. Diese Variante eignet sich insbesondere dann, wenn der erfindungsgemäße Thermosäulenstrang auf einen Wicklungsträger aufgewickelt werden soll, bei dem im bewickelten Zustand mehrere Windungen nebeneinander liegen, so dass sich der effektive Wicklungsumfang nur bei jeder n-ten Windung ändert.

Die Längendifferenz zwischen den aufeinanderfolgenden Thermoelementen ist hierbei vorzugsweise im Wesentlichen gleich dem Umfang des Thermosäulenstrangs, um die Änderung des effektiven Wicklungsumfangs von einer Wicklungslage zur nächsten Wicklungslage auszugleichen.

Weiterhin eignet sich die Erfindung für einen Wicklungsträger zum bewickeln mit einem herkömmlichen Thermosäulenstrang, wie er beispielsweise in der Gebrauchsmusterschrift DE 20 2006 003 595 U1 beschrieben ist. Zum Bewickeln mit dem Thermosäulenstrang weist der Wicklungsträger einen Wicklungsbereich mit einem vorgegebenen Wicklungsumfang auf, wobei der Wicklungsumfang so an die Länge der einzelnen Thermoelemente in dem Thermosäulenstrang angepasst ist, dass die heißen Verbindungsstellen der Thermoelemente einerseits und die kalten Verbindungsstellen der Thermoelemente andererseits im aufgewickelten Zustand im Wesentlichen auf gegenüberliegenden Seiten des Wicklungsträgers angeordnet sind, um einen thermoelektrischen Generator zu bilden. Auch hierbei tritt jedoch das Problem auf, dass der effektive Wicklungsumfang des Wicklungsbereichs von einer Wicklungslage zur nächsten Wicklungslage zunimmt, was zu einer leichten Fehlpositionierung der heißen bzw. kalten Verbindungsstellen führen kann.

Der Wicklungsträger weist deshalb zusätzlich zu dem Wicklungsbereich einen Ausgleichsbereich auf, der zur Aufnahme mindestens einer Ausgleichswindung des Thermosäulenstrangs dient, wobei der Ausgleichsbereich einen anderen Wicklungsumfang aufweist als der Wicklungsbereich. Beispielsweise kann der Ausgleichsbereich einen kleineren Wicklungsumfang aufweisen als der Wicklungsbereich, so dass der geringere Umfang der Ausgleichswindung eine Positionskorrektur für die heißen und kalten Verbindungsstellen bewirkt.

In einem Ausführungsbeispiel der Erfindung besteht der Ausgleichsbereich im Wesentlichen aus einer Ringnut, die an einem Ende oder an beiden Enden des Wicklungsbereichs angeordnet ist und eine oder mehrere Ausgleichswindungen aufnehmen kann.

Hierbei ist zu erwähnen, dass der Wicklungsträger nicht notwendigerweise eine zylindrische Form aufweisen muss, wie aus dem Stand der Technik bekannt ist. Es besteht im Rahmen der Erfindung vielmehr auch die Möglichkeit, dass der Wicklungsträger anders geformt ist. Beispielsweise kann der Wicklungskörper einen ovalen, rechteckigen oder quadratischen Wicklungsquerschnitt aufweisen.

Weiterhin umfasst die Erfindung nicht nur den vorstehend beschriebenen erfindungsgemäßen Thermosäulenstrang, sondern auch einen thermoelektrischen Generator mit einem erfindungsgemäßen Thermosäulenstrang.

Weiterhin ist die Erfindung realisierbar durch ein Herstellungsverfahren für einen thermoelektrischen Generator, bei dem ein Thermosäulenstrang mit mehreren hintereinander angeordneten Thermoelementen mit jeweils zwei Thermoelementschenkeln sowie heißen Verbindungsstellen und kalten Verbindungsstellen bereitgestellt wird.

Weiterhin sieht das Herstellungsverfahren vor, dass der Thermosäulenstrang in herkömmlicher Weise auf einen Wicklungsträger aufgewickelt wird, so dass die heißen Verbindungsstellen einerseits und die kalten Verbindungsstellen andererseits auf gegenüberliegenden Seiten des Wicklungsträgers liegen. Das Aufwickeln des Thermosäulenstrangs auf den Wicklungsträger ist ebenfalls in der vorstehend genannten Gebrauchsmusterschrift DE 20 2006 003 595 U1 beschrieben, so dass der Inhalt dieser Gebrauchsmusterschrift der vorliegenden Anmeldung in vollem Umfang zuzurechnen ist.

Das Herstellungsverfahren sieht zusätzlich vor, dass die Ist-Position der heißen Verbindungsstellen und/oder der kalten Verbindungsstellen der Thermoelemente in dem Thermosäulenstrang während der Produktion erfasst wird, was beispielsweise durch einen optischen Sensor erfolgen kann.

Im Rahmen des Herstellungsverfahren wird dann eine Soll-Ist-Abweichung zwischen der ermittelten Ist-Position der Verbindungsstellen und einer vorgegebenen Soll-Position der Verbindungsstellen ermittelt.

In Abhängigkeit von der so ermittelten Soll-Ist-Abweichung wird der Thermosäulenstrang dann vor und/oder beim Aufwickeln auf den Wicklungsträger in Längsrichtung gedehnt, damit die heißen Verbindungsstellen einerseits und die kalten Verbindungsstellen andererseits im aufgewickelten Zustand möglichst exakt an den vorgesehenen Positionen auf gegenüberliegenden Seiten des Wicklungsträgers angeordnet sind.

Vorteilhaft an dem Herstellungsverfahren ist auch die Möglichkeit einer kontinuierlichen Fertigung des Thermosäulenstrangs, wie beispielsweise in DE 20 2006 003 595 U1 beschrieben ist, so dass der Inhalt dieser Gebrauchsmusterschrift der vorliegenden Beschreibung in vollem Umfang zuzurechnen ist. Bei der Herstellung des erfindungsgemäßen Thermosäulenstrangs kann also ein quasi-endloses Trägerelement (z.B. ein Draht) von einem Wicklungskörper abgewickelt und dann im abgewickelten Zustand beschichtet werden, um die einzelnen Thermoelemente mit unterschiedlicher Länge zu erzeugen. Der so gefertigte Thermosäulenstrang kann dann wieder auf einen Wicklungskörper aufgewickelt und im aufgewickelten Zustand transportiert und gelagert werden. Darüber hinaus kann der so hergestellte Thermosäulenstrang in mehrere Thermosäulenstränge vereinzelt werden, die dann jeweils einzeln auf Wicklungskörper aufgewickelt werden. Bei einer Vereinzelung eines erfindungsgemäßen Thermosäulenstrangs in mehrere Thermosäulenstränge ist es sinnvoll, wenn der jeweilige Übergang in der betreffenden Fertigungslinie erkannt werden kann. Die Erkennung der Position des Thermosäulenstrangs ist auch sinnvoll, wenn in einer Fertigungslinie ein neuer Wicklungskörper mit einem neuen Thermosäulenstrang bewickelt werden soll, da dann die exakte Positionierung der heißen bzw. kalten Verbindungsstellen wichtig ist.

Die konstruktiv vorgegebene Längenänderung der einzelnen Thermoelemente in dem erfindungsgemäßen Thermosäulenstrang bewirkt hierbei also eine Grob-Korrektur der Position der heißen bzw. kalten Verbindungsstellen, während die Dehnung des Thermosäulenstrangs eine Fein-Korrektur bewirkt.

Schließlich umfasst die Erfindung auch eine Maschine zur Ausführung des vorstehend beschriebenen Herstellungsverfahrens.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: einen Teil eines erfindungsgemäßen Thermosäulenstrangs in einer Seitenansicht,
- Figur 2A: einen thermoelektrischen Generator in einer Aufsichtsdarstellung,
- Figur 2B: eine Perspektivansicht des thermoelektrischen Generators gemäß Figur 2A,
- Figur 3A: ein Diagramm, das die Längenänderung der einzelnen Thermoelemente entlang dem Thermosäulenstrang wiedergibt,
- Figur 3B: ein entsprechendes Diagramm für ein anderes Ausführungsbeispiel eines erfindungsgemäßen Thermosäulenstrangs,
- Figur 4: eine stark vereinfachte schematische Darstellung einer Maschine zur Herstellung eines thermoelektrischen Generators,
- Figur 5: das Herstellungsverfahren in Form eines Flussdiagramms,
- Figur 6A: einen Wicklungsträger in einer Seitenansicht sowie
- Figur 6B: den Wicklungsträger gemäß Figur 6A mit zwei Wicklungslagen eines Thermosäulenstrangs.

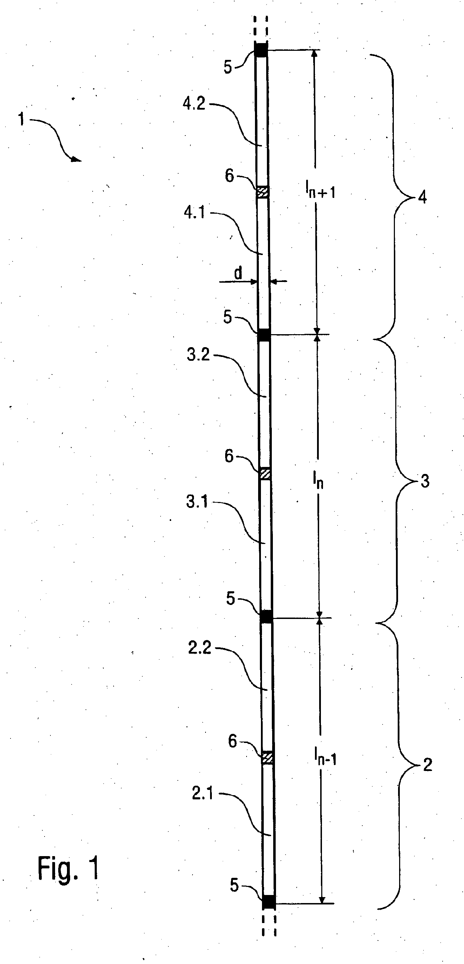

Figur 1 zeigt einen Teil eines erfindungsgemäßen Thermosäulenstrangs 1 mit mehreren hintereinander angeordneten und elektrisch in Reihe geschalteten Thermoelementen 2, 3, 4, wobei die einzelnen Thermoelemente 2-4 jeweils zwei Thermoelementschenkel 2.1, 2.2, 3.1, 3.2, 4.1, 4.2 aufweisen.

Die einzelnen Thermoelementschenkel 2.1, 2.2, 3.1, 3.2, 4.1, 4.2 sind jeweils durch heiße Verbindungsstellen 5 und kalte Verbindungsstellen 6 miteinander verbunden. Bei einer Herstellung eines thermoelektrischen Generators aus dem Thermosäulenstrang 1 werden die heißen Verbindungsstellen 5 dann einer größeren Temperatur ausgesetzt als die kalten Verbindungsstellen 6, woraufhin der Thermosäulenstrang 1 eine entsprechende Thermospannung erzeugt.

Der detaillierte konstruktive Aufbau und die Herstellungsweise des Thermosäulenstrangs 1 ist weitgehend in der Gebrauchsmusterschrift DE 20 2006 003 595 U1 beschrieben, so dass der Inhalt dieser Gebrauchsmusterschrift der vorliegenden Anmeldung hinsichtlich des konstruktiven Aufbaus und der Herstellung des Thermosäulenstrangs 1 in vollem Umfang zuzurechnen ist.

Eine erfindungsgemäße Besonderheit des Thermosäulenstrangs 1 gegenüber den herkömmlichen Thermosäulensträngen besteht darin, dass die einzelnen Thermoelemente 2, 3, 4 unterschiedliche Längen lₙ₊₁, lₙ, lₙ₋₁ aufweisen, wobei die Länge der einzelnen Thermoelemente 2-4 in Längsrichtung des Thermosäulenstrangs 1 monoton zunimmt, d.h. es gilt lₙ₋₁≤lₙ≤lₙ₊₁, wobei zumindest bei zwei aufeinander folgenden Thermoelementen eine Längendifferenz auftritt. Diese Längenänderung der einzelnen Thermoelemente 2-4 entlang dem Thermosäulenstrang 1 soll im aufgewickelten Zustand die Änderung des effektiven Wicklungsdurchmessers von einer Wicklungslage zur nächsten Wicklungslage kompensieren.

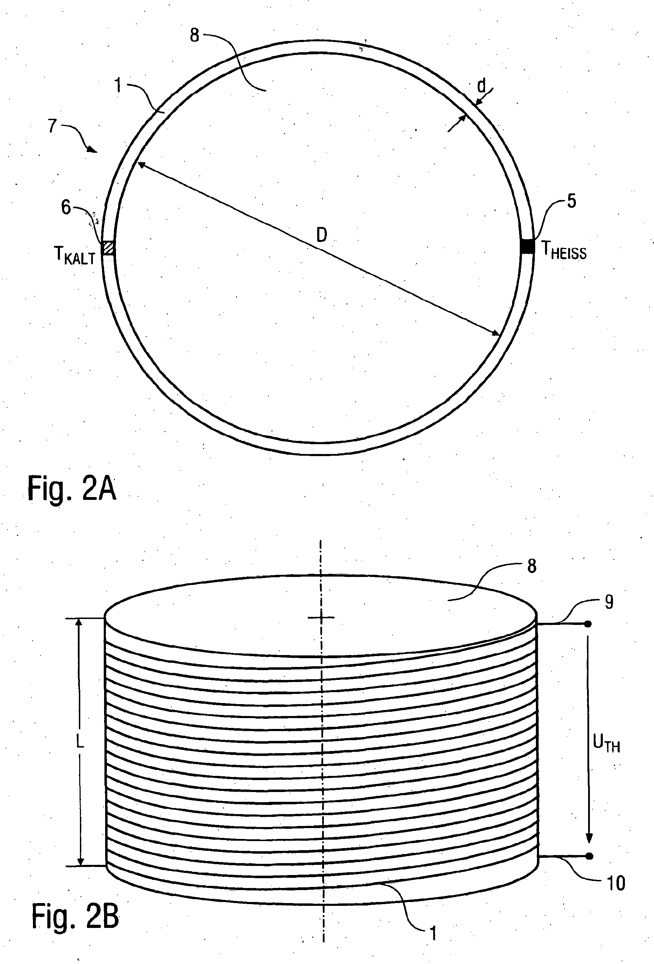

Die Figuren 2A und 2B zeigen einen erfindungsgemäßen thermoelektrischen Generator mit einem zylindrischen Wicklungsträger 8, der mit dem erfindungsgemäßen Thermosäulenstrang 1 bewickelt ist. Der Durchmesser D des Wicklungsträgers 8 ist hierbei so auf die Länge lₙ₋₁, lₙ, lₙ₊₁ der einzelnen Thermoelemente 2-4 und den Durchmesser d des Thermosäulenstrangs 1 abgestimmt, dass die heißen Verbindungsstellen 5 einerseits und die kalten Verbindungsstellen 6 andererseits möglichst exakt auf gegenüberliegenden Seiten des Wicklungsträgers 8 liegen.

Der Wicklungsträger 8 weist hierbei eine Wicklungslänge L auf, so dass auf der Mantelfläche des Wicklungsträgers 8 eine Anzahl m=L/d Windungen des Thermosäulenstrangs 1 nebeneinander Platz haben und jeweils eine gemeinsame Wicklungslage bilden. In der nächsten Wicklungslage ändert sich dagegen der effektive Wicklungsumfang des Wicklungsträgers 8 durch die darunter liegende Wicklungslage, so dass das n-te Thermoelement 2 mit n=m+1 eine größere Länge lₙ aufweist als die vorangehenden Thermoelemente 3, 4. Die Längendifferenz zwischen dem (n-1)-ten Thermoelement 2 und dem n-ten Thermoelement 3 entspricht hierbei dem Umfang des Thermosäulenstrangs 1.

Auf diese Weise wird erreicht, dass die heißen Verbindungsstellen 5 einerseits und die kalten Verbindungsstellen 6 andererseits auch in den oberen Wicklungslagen exakt an gegenüberliegenden Stellen des Wicklungsträgers 8 liegen.

Weiterhin ist zu erwähnen, dass der thermoelektrische Generator 7 zwei Spannungsabgriffe 9, 10 aufweist, die mit den gegenüberliegenden Enden des Thermosäulenstrangs 1 verbunden sind und eine entsprechende Thermospannung U_{TH} abgeben.

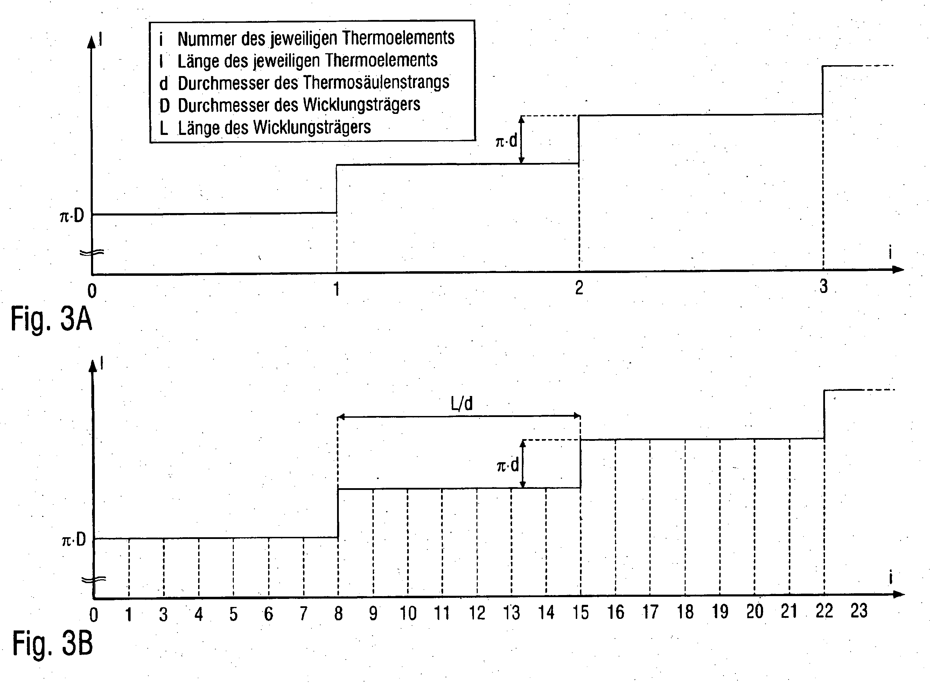

Die Figuren 3A und 3B zeigen verschiedene mögliche Verläufe der Länge lᵢ der aufeinanderfolgenden Thermoelemente in einem erfindungsgemäßen Thermosäulenstrang.

Bei dem Ausführungsbeispiel gemäß Figur 3A nimmt die Länge lᵢ der aufeinanderfolgenden Thermoelemente jeweils von einem Thermoelement zum nächsten Thermoelement um den Umfang U=π·d des Thermosäulenstrangs zu. Diese Längenänderung eignet sich insbesondere für bandförmige Thermosäulenstränge, bei denen jede Windung des Thermosäulenstrangs zu einer neuen Wicklungslage gehört.

Bei dem Ausführungsbeispiel gemäß Figur 3B weist dagegen nur jedes siebte Thermoelement eine entsprechende Längenänderung gegenüber dem vorangehenden Thermoelements auf. Dieser Verlauf der Länge der einzelnen Thermoelemente eignet sich insbesondere zur Bewicklung von Wicklungsträgern bei denen sieben Windungen des Thermosäulenstrangs jeweils nebeneinander liegen und eine gemeinsame Wicklungslage bilden.

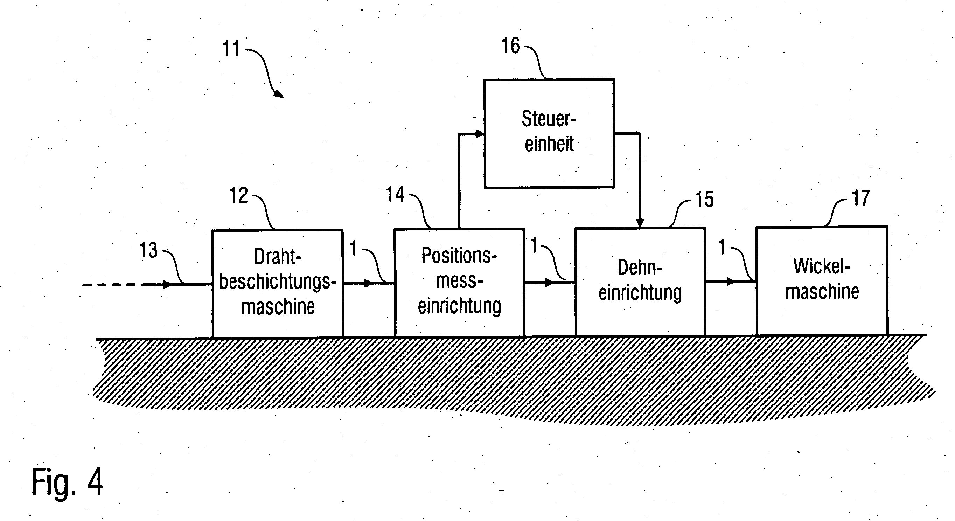

Figur 4 zeigt eine grob vereinfachte Darstellung einer Maschine 11 zur Herstellung des thermoelektrischen Generators 7 gemäß den Figuren 2A und 2B.

Zunächst weist die Maschine eine herkömmliche Drahtbeschichtungsmaschine 12 auf, der ein herkömmlicher Draht 13 als Ausgangsprodukt zugeführt wird. Die Drahtbeschichtungsmaschine 12 erzeugt dann den Thermosäulenstrang 1, wobei der Draht 13 das Trägerelement des Thermosäulenstrangs 1 bildet, wie beispielsweise in der Gebrauchsmusterschrift DE 20 2006 003 595 U1 beschrieben ist. Bei der Herstellung des Thermosäulenstrangs 1 kann die Drahtbeschichtungsmaschine 12 Beschichtungen aus Isoliermaterial oder Leitermaterial auf den Draht 13 aufbringen oder partiell Beschichtungen von dem Draht 13 wieder entfernen, wie in der Gebrauchsmusterschrift DE 20 2006 003 595 U1 beschrieben ist, so dass der Inhalt dieser Gebrauchsmusterschrift hinsichtlich der Herstellung des erfindungsgemäßen Thermosäulenstrangs 1 in vollem Umfang zuzurechnen ist.

Der Thermosäulenstrang 1 wird dann einer Positionsmesseinrichtung 14 zugeführt, die mit einem geeigneten Sensor die Position der heißen Verbindungsstellen 5 und der kalten Verbindungsstellen 6 ermittelt. Bei dem Sensor zur Positionserkennung kann es sich beispielsweise um einen optischen Sensor handeln, jedoch sind im Rahmen der Erfindung auch andere Sensortypen einsetzbar.

Der auf diese Weise vermessene Thermosäulenstrang 1 wird dann einer Dehneinrichtung 15 zugeführt, welche den Thermosäulenstrang 1 in Längsrichtung variabel dehnt. Die Dehnung des Thermosäulenstrangs 1 wird hierbei durch eine Steuereinheit 16 in Abhängigkeit von der zuvor ermittelten Position der heißen Verbindungsstellen 5 bzw. der kalten Verbindungsstellen 6 so gesteuert, dass die Verbindungsstellen 5, 6 in dem fertigen thermoelektrischen Generator exakt an der vorgesehenen Position liegen.

Der so gedehnte Thermosäulenstrang 1 wird dann einer herkömmlichen Wickelmaschine 17 zugeführt, welche den Thermosäulenstrang 1 auf den Wicklungsträger 8 aufwickelt.

Die konstruktiv vorgesehene Längenänderung der einzelnen Thermoelemente 2-4 in dem Thermosäulenstrang 1 bewirkt hierbei eine Grob-Korrektur der Position der Verbindungsstellen 5, 6 in den aufeinanderfolgenden Wicklungslagen.

Die Dehnung des Thermosäulenstrangs 1 durch die Dehneinrichtung 15 bewirkt dagegen eine zusätzliche Fein-Korrektur der Position der Verbindungsstellen 5, 6.

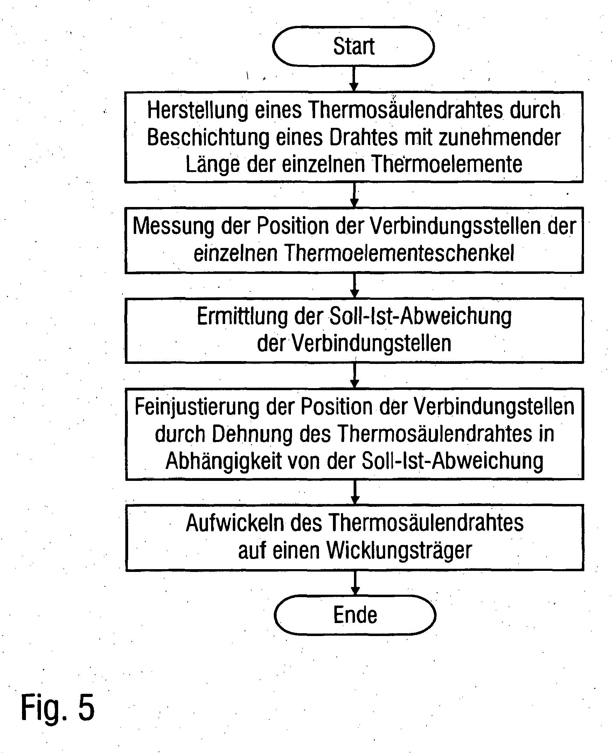

Figur 5 zeigt schließlich das Herstellungsverfahren der Maschine 11 gemäß Figur 4 in Form eines Flussdiagramms, wie sich bereits aus der vorstehenden Beschreibung ergibt.

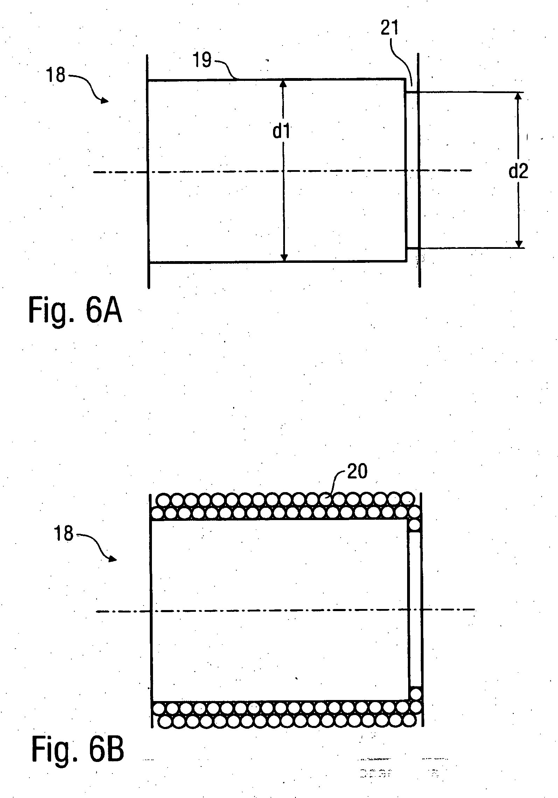

Die Figuren 6A und 6B zeigen ein anderes Ausführungsbeispiel eines erfindungsgemäßen thermoelektrischen Generators 18 mit einem Wicklungsträger 19, der mit einem herkömmlichen Thermosäulenstrang 20 bewickelt werden kann, wie er beispielsweise aus der Gebrauchsmusterschrift DE 20 2006 003 595 U1 bekannt ist. Der Thermosäulenstrang 20 weist also eine einheitliche Länge der einzelnen Thermoelemente auf.

Die Änderung des effektiven Wicklungsdurchmessers in den übereinanderliegenden Wicklungslagen wird hierbei dadurch kompensiert, dass an einem Ende des Wicklungsträgers 19 eine Ringnut 21 angeordnet ist, die eine oder mehrere Windungen des Thermosäulenstrangs 20 aufnimmt und einen Wicklungsdurchmesser d2 aufweist, der gegenüber dem Wicklungsdurchmesser d1 des sonstigen Wicklungsträgers 19 verringert ist. Die Windungen des Thermosäulenstrangs 20 in der Ringnut 21 bilden also Ausgleichswindungen für den vergrößerten Wicklungsumfang in der jeweils folgenden Wicklungslage.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen.

## Patentansprüche

1. Thermosäulenstrang (1) mit
a) mehreren hintereinander angeordneten Thermoelementen (2, 3, 4) mit jeweils zwei Thermoelementschenkeln (2.1, 2.2, 3.1, 3.2, 4.1, 4.2) mit jeweils einer bestimmten Länge (lₙ₋₁, lₙ, lₙ₊₁) sowie mit heißen Verbindungsstellen (5) und kalten Verbindungsstellen (6),
b) wobei der Thermosäulenstrang (1) auf einen Wicklungsträger (8) aufwickelbar ist, so dass die heißen Verbindungsstellen (5) einerseits und die kalten Verbindungsstellen (6) andererseits auf gegenüber liegenden Seiten des Wicklungsträgers (8) angeordnet sind,
**dadurch gekennzeichnet,**
c) **dass** die Länge (lₙ₋₁, lₙ, lₙ₊₁) der einzelnen Thermoelemente (2-4) und/oder die Länge der einzelnen Thermoelementschenkel (2.1, 2.2, 3.1, 3.2, 4.1, 4.2) entlang dem Thermosäulenstrang (1) monoton zunimmt oder monoton abnimmt, und
d) **dass** diese Längenänderung entlang dem Thermosäulenstrang (1) im aufgewickelten Zustand die Änderung des effektiven Wicklungsdurchmessers von einer Wicklungslage zur nächsten Wicklungslage kompensiert,
e) so dass die heißen Verbindungsstellen (5) und die kalten Verbindungsstellen (6) im aufgewickelten Zustand trotz der Änderung des effektiven Wicklungsdurchmessers von einer Wicklungslage zur nächsten Wicklungslage exakt an der vorgesehenen Position liegen.

2. Thermosäulenstrang (1) nach Anspruch 1, **dadurch gekennzeichnet, dass** alle unmittelbar aufeinander folgenden Thermoelemente (2-4) und/oder Thermoelementschenkel (2.1, 2.2, 3.1, 3.2, 4.1, 4.2) jeweils eine vorgegebene Längendifferenz aufweist.

3. Thermosäulenstrang nach Anspruch 1, **dadurch gekennzeichnet, dass** die unmittelbar aufeinander folgenden Thermoelemente (2-4) und/oder Thermoelementschenkel (2.1, 2.2, 3.1, 3.2, 4.1, 4.2) nur bei jedem n-ten Thermoelement eine vorgegebene Längendifferenz aufweisen und ansonsten die gleiche Länge aufweisen.

4. Thermosäulenstrang (1) nach Anspruch 2 oder 3, **dadurch gekennzeichnet, dass** die Längendifferenz der aufeinander folgenden Thermoelemente im Wesentlichen gleich dem Umfang (π·d) des Thermosäulenstrangs ist.

5. Thermoelektrischer Generator (7, 18) mit einem Thermosäulenstrang (1) nach einem der Ansprüche 1 bis 4.

## Claims

1. A thermopile wire (1) with
a) several thermocouples (2, 3, 4) disposed one behind the other and each having two thermocouple legs (2.1, 2.2, 3.1, 3.2, 4.1, 4.2) each being of a specific length (lₙ₋₁, lₙ, lₙ₊₁) and with hot connection points (5) and cold connection points (6),
b) wherein the thermopile wire (1) can be wound on a winding support (8), so that the hot connection points (5) on the one hand and the cold connection points (6) on the other hand are disposed on opposite sides of the winding support (8),
**characterized in that**
c) the length (lₙ₋₁, lₙ, lₙ₊₁) of the individual thermocouples (2-4) and/or the length of the individual thermocouple legs (2.1, 2.2, 3.1, 3.2, 4.1, 4.2) monotonously increases or monotonously decreases along the thermopile wire (1), and
d) in a wound up state, said change of length along the thermopile wire (1) compensates for the change of the effective winding diameter from one winding layer to the next winding layer,
e) so that, in the wound up state, the hot connection points (5) and the cold connection points (6) lie exactly at the designated position notwithstanding the change of the effective winding diameter from one winding layer to the next winding layer.

2. The thermopile wire (1) according to Claim 1, **characterized in that** all of the directly successive thermocouples (2-4) and/or thermocouple legs (2.1, 2.2, 3.1, 3.2, 4.1, 4.2) each have a given difference in length.

3. The thermopile wire according to Claim 1, **characterized in that** the directly successive thermocouples (2-4) and/or thermocouple legs (2.1, 2.2, 3.1, 3.2, 4.1, 4.2) have a given difference in length only in the case of every n^{th} thermocouple and otherwise are of the same length.

4. The thermopile wire (1) according to Claim 2 or 3, **characterized in that** the difference in length of the successive thermocouples is substantially the same as the perimeter (π·d) of the thermopile wire.

5. Thermoelectric generator (7, 18) with a thermopile wire (1) according to one of claims 1 to 4.

## Revendications

1. Faisceau de thermopile (1) comportant
a) plusieurs thermo-éléments disposés les uns derrière les autres (2, 3, 4) dotés respectivement de deux branches de thermo-éléments (2.1, 2.2, 3.1, 3.2, 4.1, 4.2) présentant respectivement une longueur déterminée (1ₙ₋₁, 1ₙ, 1ₙ₊₁) et de points de liaison chauds (5) et de points de liaison froids (6),
b) dans lequel le faisceau de thermopile (1) peut être enroulé sur un support d'enroulement (8) de sorte que les points de liaison chauds (5) d'une part et les points de liaison froids (6) d'autre part sont disposés sur des côtés opposés du support d'enroulement (8),
**caractérisé en ce**
c) **que** la longueur (1ₙ₋₁, 1ₙ, 1ₙ₊₁) des divers thermo-éléments (2-4) et/ou la longueur des diverses branches de thermo-éléments (2.1, 2.2, 3.1, 3.2, 4.1, 4.2) augmente de façon uniforme ou diminue de façon uniforme le long du faisceau de thermopile (1), et
d) **que** cette modification de longueur le long du faisceau de thermopile (1) compense à l'état enroulé la modification du diamètre d'enroulement effectif d'un état d'enroulement à l'état d'enroulement suivant,
e) de sorte que les sites de liaison chauds (5) et les sites de liaison froids (6) à l'état enroulé se trouvent exactement à la position prévue malgré la modification du diamètre d'enroulement effectif d'un état d'enroulement à l'état d'enroulement suivant.

2. Faisceau de thermopile (1) selon la revendication 1, **caractérisé en ce que** tous les thermo-éléments (2-4) et/ou branches de thermo-éléments (2.1, 2.2, 3.1, 3.2, 4.1, 4.2) immédiatement consécutifs présentent respectivement une différence de longueur prédéterminée.

3. Faisceau de thermopile selon la revendication 1, **caractérisé en ce que** les thermo-éléments (2-4) et/ou branches de thermo-éléments (2.1, 2.2, 3.1, 3.2, 4.1, 4.2) immédiatement consécutifs présentent seulement à chaque nième thermo-élément une différence de longueur prédéterminée et présentent sinon la même longueur.

4. Faisceau de thermopile (1) selon la revendication 2 ou 3, **caractérisé en ce que** la différence de longueur des thermo-éléments consécutifs est essentiellement identique au pourtour (π-d) du faisceau de thermopile.

5. Générateur thermoélectrique (7, 18), comportant un faisceau de thermopile (1) selon l'une des revendications 1 à 4.
